# EUROPEAN PATENT APPLICATION

(11) **EP 3 828 917 A1**
(43) Date of publication of application: **02.06.2021**
(21) Application number: 18927273.5
(22) Date of filing: 25.07.2018
(51) Int. Cl.: H01L 21/02, H01L 21/56, H01L 23/12

(54) **DETERMINATION DEVICE AND CHIP INSTALLATION APPARATUS EQUIPPED WITH SAME**

(71) Applicant: Fuji Corporation, Chiryu-shi, Aichi 472-8686 (JP)
(72) Inventor: KUSUNOKI, Kazuhiro, Chiryu-shi, Aichi 472-8686 (JP)
(74) Representative: Grünecker Patent- und Rechtsanwälte PartG mbB
(86) International application number: PCT/JP2018/027985
(87) International publication number: WO 2020/021666

(57) **Abstract**

A determination device determines a disposing position of a chip disposed on a support used to manufacture a Fan-Out Wafer Level Package or a Fan-Out Panel Level Package. The determination device includes a first chip information acquisition section configured to acquire first chip information relating to a type of a first-type chip and the number of the first-type chips to be supplied, a second chip information acquisition section configured to acquire second chip information relating to a type of a second-type chip different from the first-type chip and the number of second-type chips to be supplied, and a determination section configured to determine disposing positions of the first-type chip and the second-type chip based on the first chip information and the second chip information. When the first-type chip and the second-type chip are disposed on the same support, an area of a region in which the first-type chip is disposed and an area of a region in which the second-type chip is disposed are changeable.

## Description

### Technical Field

A technique disclosed in the present specification relate to a technique for suitably manufacturing a Fan-Out Wafer Level Package or a Fan-Out Panel Level Package, for example. In particular, the present specification relates to a determination device for determining a position at which a chip is disposed on a support used in manufacturing the package, and a chip mounting device equipped with the determination device.

### Background Art

A Fan-Out Wafer Level Package (FOWLP) or a Fan-Out Panel Level Package (FOPLP) has been developed. For example, JP-A-2015-213152 discloses a FOWLP. In this package manufacturing method, a large-sized panel is used to increase the number of chips disposed on one panel, and thus, a manufacturing cost is reduced. Moreover, in the manufacturing method of this package, the panel is divided into four blocks by a horizontal bar and a vertical bar. In one block, it is possible to dispose a chip having a type different from those of the chips disposed in the other three blocks.

### Summary of the Invention

### Technical Problem

In JP-A-2015-213152, a large number of chips can be disposed on a large-sized panel. An inside of one panel is divided into multiple blocks by a horizontal bar and a vertical bar, and different types of chips can be disposed for each of the divided blocks. Therefore, in the panel of JP-A-2015-213152, it is possible to dispose multiple types of chips in one panel. However, the number or types of packages required for users are differed for each user. Therefore, when only the same type of chips are disposed on one panel, it is not necessary to divide the panel into multiple blocks, in the panel of JP-A-2015-213152, there is a problem that the number of chips which can be disposed on the panel is reduced by an area where the horizontal bar and the vertical bar are disposed, and thus, the number of packages which can be manufactured is reduced. Further, when multiple types of chips are disposed on one panel, in the panel of JP-A-2015-213152, since a region of the panel divided by the horizontal bar and the vertical bar is fixed, there is a problem that chips cannot be disposed flexibly according to the number and types of packages required. The present specification discloses a technique for manufacturing a package capable of flexibly coping with the number and type of packages required.

### Solution to Problem

A determination device disclosed in the present specification determines a disposing position of a chip disposed on a support used to manufacture a Fan-Out Wafer Level Package or a Fan-Out Panel Level Package. The determination device includes: a first chip information acquisition section configured to acquire first chip information relating to a type of a first-type chip and the number of the first-type chips to be supplied; a second chip information acquisition section configured to acquire second chip information relating to a type of a second-type chip and the number of the second-type chips to be supplied, the second-type chip being different from the first-type chip; and a determination section configured to determine disposing positions of the first-type chip and the second-type chip based on the first chip information and the second chip information. When the first-type chip and the second-type chip are disposed on the same support, an area of a region in which the first-type chip is disposed and an area of a region in which the second-type chip is disposed are changeable.

In the above determination device, when the first-type chip and the second-type chip are disposed on the same support, the area of the region in which the first-type chip is disposed and the area of the region in which the second-type chip is disposed are changeable. That is, the area of the region in which the first-type chip is disposed and the area of the region in which the second-type chip is disposed are not fixed, and can be changed based on the number and sizes of the first-type chips and the number and sizes of the second-type chips disposed on the support. Therefore, for example, it is possible to determine the disposing positions of the first-type chip and the second-type chip so as to minimize the number of supports. That is, when different types of chips are disposed on one support, the determination section can flexibly determine the disposing positions according to the types and numbers of various chips. As a result, it is possible to suppress the occurrence of a portion in which a chip is not disposed on the support, and it is possible to efficiently dispose the chip on the support. Therefore, it is possible to suppress an increase in the number of supports required to manufacture a package, and to reduce a manufacturing cost of the package.

Moreover, a chip mounting device disclosed the present specification mounts a chip on a support. The chip mounting device includes the above determination device and a moving device configured to move the chip onto the support according to a disposing position determined by the determination device.

The chip mounting device moves the chip onto the support according to the disposing position determined by the determination device. Therefore, it is possible to provide the same operation and effect as those of the above determination device.

### Brief Description of Drawings

Fig. 1 is a cross-sectional view schematically illustrating a configuration of a package manufactured using a package mounting device according to Embodiment.
Fig. 2 is a cross-sectional view illustrating a schematic configuration of a manufacturing step of the package.
Fig. 3 is a diagram illustrating a schematic configuration of a chip mounting device.
Fig. 4 is a flowchart illustrating an example of a process in which a chip mounting device disposes a chip on a support, in Embodiment 1.
Fig. 5 is a diagram illustrating an example of a disposing position of the chip to be determined by a determination section, in Embodiment 1.
Fig. 6 is a flowchart illustrating an example of a process in which the chip mounting device disposes the chip on the support, in Embodiment 2.
Fig. 7 is a diagram illustrating a pattern of a disposition region of the two types of chips provided on one support, in Embodiment 2.
Fig. 8 is a diagram illustrating an example of a disposing position of the chip on the support when manufacturing both a package including one chip and a package including multiple chips.

### Description of Embodiments

Main features of Embodiments described below are listed below. Technical elements described below are independent technical elements, respectively, and exhibit technical usefulness alone or by various combinations, and are not limited to the combinations described in claims at the time of filing.

In an determination device disclosed in the present specification, when a first-type chip and a second-type chip are disposed on N (N is a natural number of 2 or more) supports, the determination section may determine disposing positions of the first-type chip and the second-type chip such that a region in which a first-type chip is disposed and a region in which a second-type chip is disposed are at the same position on each of the N supports. With such a configuration, the determination section determines the disposing positions of the first-type chip and the second-type chip such that the region in which the first-type chip is disposed and the region in which the second-type chip is disposed are in the same disposition in all of the multiple supports. Accordingly, production programs for producing the packages can be the same as each other.

In the determination device disclosed in the present specification, when the first-type chip and the second-type chip are disposed on N (N is a natural number of 2 or more) supports, the determination section may determine the disposing positions of the first-type chip and the second-type chip such that, in at least one support, only one of at least the first-type chip and the second-type chip is disposed on the support, and determine the disposing positions of the first-type chip and the second-type chip such that, in at least one other support, the first-type chip and the second-type chip are disposed on the support. With such a configuration, it is possible to manufacture one type of package manufactured by disposing only the same type of chip on one support, and multiple types of packages manufactured by disposing multiple types of chips on one support. Thus, it is possible to flexibly respond to a user's request to manufacture multiple types of packages.

### EMBODIMENT

### Embodiment 1

Hereinafter, chip mounting device 10 according to Embodiment will be described. Chip mounting device 10 is a device used for manufacturing package 50. First, package 50 manufactured using chip mounting device 10 of the present Embodiment will be described.

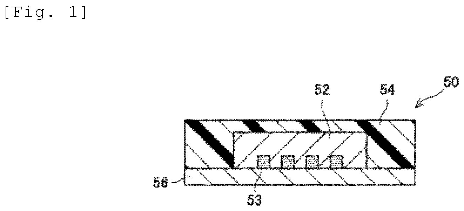

Fig. 1 schematically illustrates a configuration of package 50. As illustrated in Fig. 1, package 50 includes chip 52, molding material 54, and wiring layer 56. In the present Embodiment, package 50 is a Fan-Out Wafer Level Package (FOWLP) or a Fan-Out Panel Level Package (FOPLP).

Chip 52 is a flat plate shape, and includes multiple electrode pads 53 on one surface. In chip 52, a surface on which electrode pads 53 are formed abuts on wiring layer 56, other surface thereof is coated with molding material 54. A wire, a bump, or the like (not illustrated) (hereinafter, simply referred to as a "wire") is formed in wiring layer 56 so as to electrically connect each electrode pad 53. When package 50 is mounted on a circuit board or the like, wiring layer 56 is disposed so as to abut on the circuit board or the like.

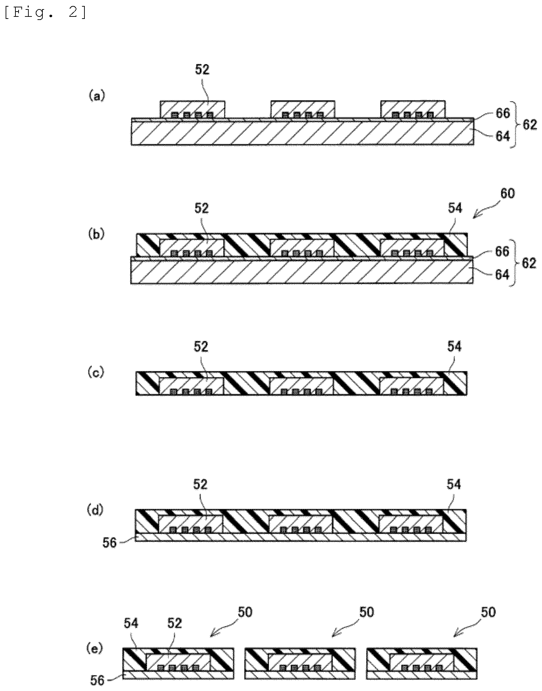

Next, an outline of a manufacturing step of package 50 will be described with reference to Fig. 2. As illustrated in Fig. 2(a), first, multiple chips 52 are placed on support 62. Support 62 includes glass plate 64 and adhesive tape 66 which is adhered to a surface of glass plate 64. In adhesive tape 66, an adhesive is applied to both surfaces, one surface is adhered to the surface of glass plate 64, and chip 52 is adhered to the other surface. When chip 52 is placed on support 62 (that is, adhesive tape 66), chip 52 is fixed at a position placed by adhesive tape 66. Multiple chips 52 are respectively fixed at predetermined positions on one support 62. Next, as illustrated in Fig. 2(b), a periphery of chip 52 is covered with molding material 54. Next, as illustrated in Fig. 2(c), support 62 is peeled off from mold body 60. Then, chip 52 (specifically, the surface on which electrode pads 53 of chip 52 are formed) is exposed. Next, as illustrated in Fig. 2(d), wiring layer 56 is formed on the exposed surface of chip 52. Then, as illustrated in Fig. 2(e), division (singulation) into a structure including chip 52, molding material 54, and wiring layer 56 is performed so as to include each chip 52. In this manner, multiple packages 50 are manufactured at once.

In a placement step of chips 52 illustrated in Fig. 2(a), a manufacturing cost can be reduced by disposing large number of chips 52 on large-sized support 62. In the present Embodiment, a relatively large-sized support 62 of 600 × 600 mm is used. A dimension of support 62 is not particularly limited and can be appropriately selected according to the number and type of package 50 to be manufactured. Chip mounting device 10 of the present Embodiment is used when chip 52 is placed on support 62 illustrated in Fig. 2(a).

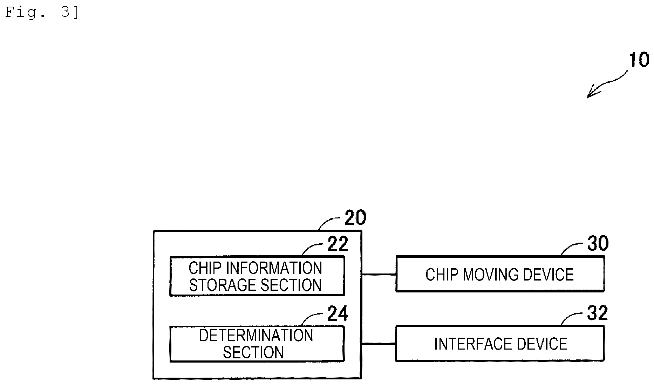

As illustrated in Fig. 3, chip mounting device 10 includes computing device 20, chip moving device 30, and interface device 32.

For example, computing device 20 may be constituted by a computer including CPU, ROM, RAM, or the like. When the computer executes a program, computing device 20 functions as determination section 24 or the like illustrated in Fig. 3. Processing executed by computing device 20 will be described in detail later.

As illustrated in Fig. 3, computing device 20 includes chip information storage section 22. Chip information storage section 22 stores information relating to chip 52 to be sealed in package 50. The information relating to chip 52 may include a type of chip 52 including a shape and dimensions of chip 52, and the number of chips 52 to be supplied (that is, the number of packages 50 to be manufactured). A user inputs the information relating to chip 52 into interface device 32. The input information is input from interface device 32 to computing device 20 and stored in chip information storage section 22. Computing device 20 is an example of a "determination device".

Chip moving device 30 is configured to dispose chip 52 supplied from a chip supplying device (not illustrated) on support 62. More specifically, the chip moving device 30 dispose multiple chips 52 at positions set on support 62. The position of chip 52 disposed by chip moving device 30 is determined by computing device 20 (more specifically, determination section 24 of computing device 20). That is, chip moving device 30 disposes chip 52 on support 62 based on the information relating to the disposing position of chip 52 transmitted from computing device 20. Since chip moving device 30 can be a device used in a known package manufacturing device, detailed descriptions of a configuration of chip moving device 30 are omitted. Moreover, chip moving device 30 is an example of a "moving device".

Interface device 32 is a display device which provides a user with various types of information of chip moving device 30, and is an input device which receives an instruction and information from an operator. For example, the user can receive an input such as information (that is, the type and number of chips 52 supplied) on chip 52 manufactured to package 50 through interface device 32. Interface device 32 is an example of a "first chip information acquisition section" and a "second chip information acquisition section".

Next, a process of disposing chip 52 on support 62 by chip mounting device 10 will be described. The present Embodiment describes a process of disposing two types of chips 52a and 52b on support 62 when two types of packages 50 such as package 50 including chip 52a and package 50 including chip 52b are manufactured.

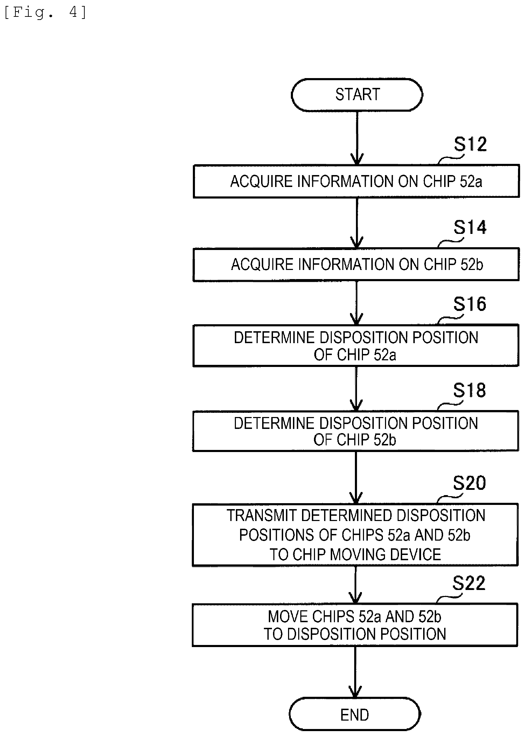

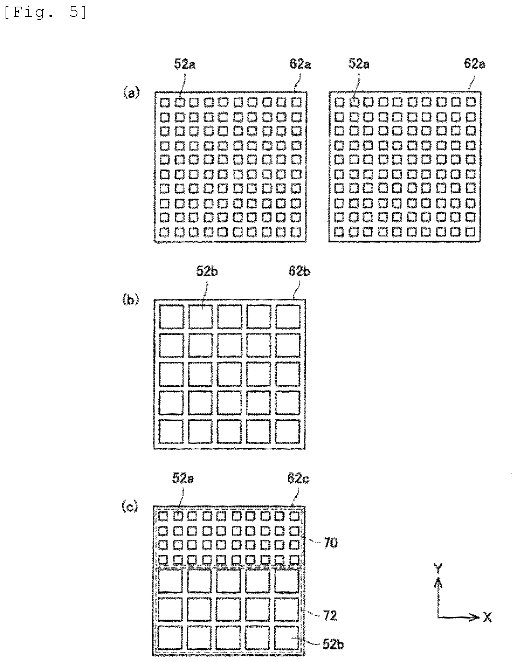

As illustrated in Fig. 4, first, computing device 20 acquires information relating to chip 52a from chip information storage section 22 (S12). The information relating to chip 52a is a type (that is, a mold number for specifying the type of chip 52a, or the like) of chip 52a and the number of chips 52a to be supplied. The information relating to chip 52a is previously input by the user to interface device 32. The information relating to chip 52a input to interface device 32 is transmitted from interface device 32 to computing device 20. Computing device 20 stores the received information relating to chip 52a in chip information storage section 22. Chip information storage section 22 stores information relating to the type of chip 52 and a shape, dimensions, or the like of chip 52 corresponding to chip 52. Therefore, computing device 20 can acquire information relating to the shape, dimensions, or the like of chip 52a based on the information relating to type of chip 52a. For example, as illustrated in Fig. 5(a), chip 52a is substantially square in a plan view, and chips 52 are disposed in 10 rows × 10 columns when only chips 52a are disposed on support 62. In the present Embodiment, the number of chips 52a to be supplied is 240.

Next, computing device 20 acquires information relating to chip 52b from chip information storage section 22 (S14). The information relating to chip 52b is stored in chip information storage section 22 in advance, and is acquired in the same manner as in Step S12 described above. For example, as illustrated in Fig. 5(b), chip 52b is substantially square in a plan view, and chips 52b are disposed in 5 rows × 5 columns when only chips 52b are disposed on support 62. In the present Embodiment, the number of chips B to be supplied is 40.

Next, in Step S16, determination section 24 of computing device 20 determines the disposing position of chip 52a based on the information relating to chip 52a acquired in Step S12. In the present Embodiment, a total of 100 chip 52a in 10 rows × 10 columns can be disposed on one support 62, and all 240 chips 52a are supplied. Determination section 24 determines that only 100 chips A are disposed on each of two supports 62 and remaining 40 chips A are disposed on one support 62. That is, as illustrated in Fig. 5(a), determination section 24 determines that only chips 52a are disposed in 10 rows × 10 columns on the same support 62a with respect to two supports 62a. Then, as illustrated in Fig. 5(c), determination section 24 determines that remaining 40 chips 52a are disposed on one support 62c (more specifically, in region 70 of support 62c) in 4 rows × 10 columns.

Next, in Step S18, determination section 24 determines the disposing position of chip 52b based on the information relating to chip 52b acquired in Step S14. In the present embodiment, a total of 25 chips 52b in 5 rows × 5 columns can be disposed on one support 62, and all 40 chips 52b are supplied. Determination section 24 determines that only 25 chips B are disposed on one support 62. Then, determination section 24 determines that remaining 15 chips 52b are disposed on support 62 on which chips 52a are disposed in 4 rows × 10 columns. That is, as illustrated in Fig. 5(b), determination section 24 determines that only chips 52b are disposed in 5 rows × 5 columns on one support 62b. Then, as illustrated in Fig. 5(c), determination section 24 determines that remaining 15 chips 52b are disposed in 3 rows × 5 columns on support 62c (specifically, in region 72 of support 62c) where chips 52a are disposed in region 70.

As determination section 24 determines the disposing positions of chips 52a and 52b as described above, as illustrated in Fig. 5(c), region 70 in which chips 52a are disposed and region 72 in which chips 52b are disposed are provided on support 62c on which both chips 52a and 52b are disposed. An area of each of regions 70 and 72 is determined according to the number of chips 52a and 52b to be supplied. In the present Embodiment, in support 62c, a range of 2/5 is region 70, and a range of 3/5 is region 72. In other words, in support 62c in which both chips 52a and 52b are disposed, a ratio of regions 70 in which chips 52a are disposed and a ratio of regions 72 in which chips 52b are disposed can be changed according to the number of chips 52a and 52b to be supplied. Since the areas of regions 70 and 72 are not fixed in advance, the disposing positions of chips 52a and 52b can be flexibly determined according to the number of chips 52a and 52b to be supplied. Therefore, a portion in which neither chips 52a nor chips 52b are disposed on support 62 is less likely to occur, and thus, chips 52a and 52b can be efficiently disposed. Accordingly, it is possible to suppress an increase in the number of necessary supports 62 and to reduce the manufacturing cost of package 50

Incidentally, a boundary between region 72 in which chips 52a are disposed and region 70 in which chips 52b are disposed may be set to a position where support 62 can be divided in an X direction or a Y direction. As described above, when package 50 is manufactured, there is a singulation step illustrated in Fig. 2(e). Therefore, if region 70 in which chips 52a are disposed and region 72 in which chips 52b is disposed are set so that support 62 can be divided in the X direction or the Y direction, it is possible to easily divide them into individual packages 50 in the singulation step. Therefore, determination section 24 of the present Embodiment sets region 70 in which chips 52a are disposed and region 72 in which chips 52b are disposed so that chips 52 of the same type are disposed in the same row (or so that chips 52 of the same type are disposed in the same column). The disposing positions of chips 52a and 52b determined in Steps S16 and S18 are stored in a memory (not illustrated) included in computing device 20.

Next, computing device 20 transmits information relating to the determined disposing positions of chips 52a and 52b to chip moving device 30 (S20). Then, chip moving device 30 disposes chips 52a and 52b on support 62 according to the received information relating to the disposing positions of chips 52a and 52b (S22).

### Embodiment 2

In Embodiment 1 described above, the disposing positions of chips 52 are determined such that only chips 52 of the same type are disposed on one support 62, and remaining chips 52 are gathered and disposed on one support 62, but a configuration is not limited to this. For example, the disposing positions of chip 52a and chip 52b may be determined such that region 70 in which chips 52a are disposed and region 72 in which chips 52b are disposed are the same in all of multiple supports 62. In the present Embodiment, processing executed by determination section 24 is different from that of Embodiment 1, and the other processing is the same as that of Embodiment 1. Therefore, descriptions of the same processing as that of Embodiment 1 are omitted.

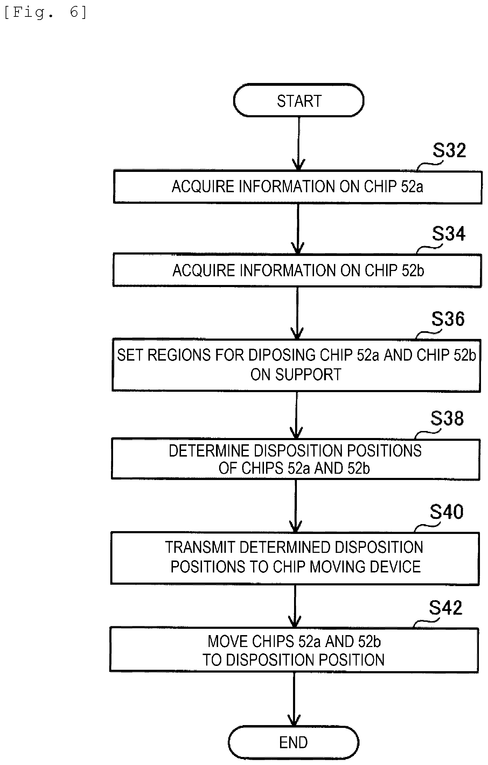

As illustrated in Fig. 6, first, computing device 20 acquires information relating to chip 52a (S32) and acquires information relating to chip 52b (S34). Processing in Steps S32 and S34 are the same as the processing in Steps S12 and S14 of Embodiment 1, respectively, and thus, detailed descriptions thereof will be omitted. Further, in the present Embodiment, chips 52a and 52b for determining the disposing positions are the same as chips 52a and 52b for determining the disposing position in Embodiment 1, and thus, the number of chips 52a and 52b to be supplied is the same (that is, 240 chips 52a and 40 chips 52b) as that Embodiment 1.

Next, determination section 24 sets region 70 in which chips 52a are disposed on support 62 and region 72 in which chips 52b are disposed on support 62, based on the acquired information relating to chips 52a and 52b (S36). In this case, region 70 in which chips 52a are disposed on support 62 and region 72 in which chips 52b are disposed on support 62 are set so that the number of supports 62 to be used is minimized. Accordingly, the number of supports 62 to be used can be reduced and the cost can be reduced. A method of setting region 70 in which chips 52a are disposed on support 62 and region 72 in which chips 52b are disposed is not particularly limited. Hereinafter, an example of a method of setting regions 70 and 72 will be described below.

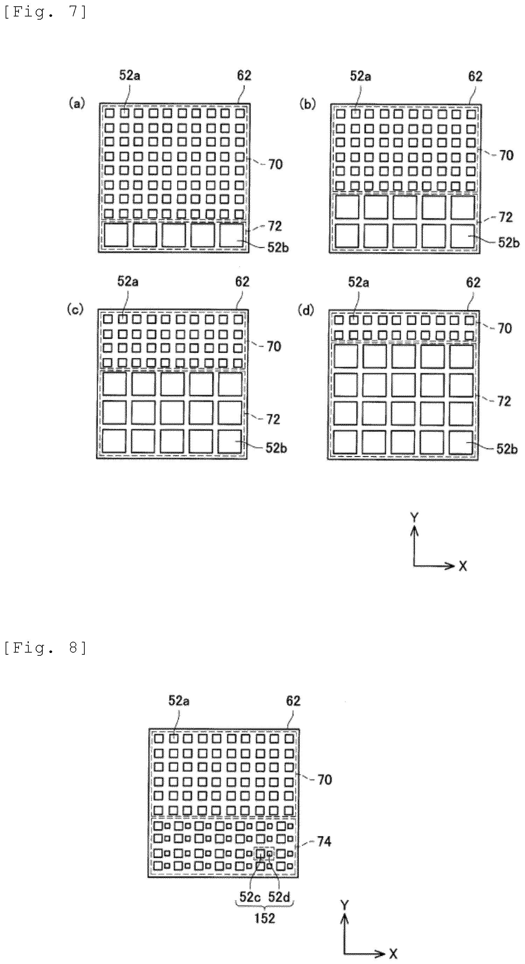

First, determination section 24 calculates all possible patterns in a case where both region 70 in which chips 52a are disposed and region 72 in which chips 52b are disposed are provided on one support 62. As described above, in order to facilitate the division into individual packages 50 in the later singulation step (refer to Fig. 2(e)), determination section 24 sets region 70 in which chips 52a are disposed and region 72 in which chips 52b are disposed so that chips 52 of the same type are disposed in the same row. Therefore, in the present Embodiment, when both region 70 in which chips 52a are disposed and region 72 in which chips 52b are disposed are provided on one support 62, there are four types of patterns illustrated in Figs. 7(a) to 7(d).

More specifically, as illustrated in Fig. 7(a), a first pattern is a pattern (hereinafter, also referred to as pattern 1) in which region 70 in which chips 52a are disposed is a range in which chips 52a can be disposed in 8 rows × 10 columns, and region 72 in which chips 52b are disposed is a range in which chips 52b can be disposed in 1 row × 5 columns. In the pattern 1, 80 chips 52a and 5 chips 52b can be disposed on one support 62.

As illustrated in Fig. 7(b), a second pattern is a pattern (hereinafter, also referred to as pattern 2) in which region 70 in which chips 52a are disposed is a range in which chips 52a can be disposed in 6 rows × 10 columns, and region 72 in which chips 52b are disposed is a range in which chips 52b can be disposed in 2 rows × 5 columns. In the pattern 2, 60 chips 52a and 10 chips 52b can be disposed on one support 62.

As illustrated in Fig. 7(c), a third pattern is a pattern (hereinafter, also referred to as pattern 3) in which region 70 in which chips 52a are disposed is a range in which chips 52a can be disposed in 4 rows × 10 columns, and region 72 in which chips 52b are disposed is a range in which chips 52b can be disposed in 3 rows × 5 columns. In the pattern 3, 40 chips 52a and 15 chips 52b can be disposed on one support 62.

As illustrated in Fig. 7(d), a fourth pattern is a pattern (hereinafter, also referred to as pattern 4) in which region 70 in which chips 52a are disposed is a range in which chips 52a can be disposed in 2 rows × 10 columns, and region 72 in which chips 52b are disposed is a range in which chips 52b can be disposed in 4 rows × 5 columns. In the pattern 4, 20 chips 52a and 20 chips 52b can be disposed on one support 62.

Next, determination section 24 calculates how many supports 62 are required for each of the four patterns. In the present Embodiment, the number of chips 52a to be supplied is 240, and the number of chips B to be supplied is 40. When chips 52a and 52b are disposed in regions 70 and 72 set in each pattern, how many supports 62 are required is calculated for each pattern.

In the pattern 1 illustrated in Fig. 7(a), 80 chips 52a and five chips 52b can be disposed on one support 62. Therefore, in order to dispose 240 chips 52a, three supports 62 are required, and in order to dispose 40 chips 52b, eight supports 62 are required. In this case, 80 chips 52a are disposed in region 70 and 5 chips 52b are disposed in region 72 on three supports 62. In five supports 62, chips 52a are not disposed in region 70, and five chips 52b are disposed in region 72. Since region 70 in which chips 52a are disposed and region 72 in which chips 52b are disposed are fixed for each pattern on support 62, even if region 70 in which chips 52a are disposed is free, chip 52b is not disposed in region 70. Therefore, in the pattern 1, a total of eight supports 62 are required.

Similarly, in the pattern 2 illustrated in Fig. 7(b), 60 chips 52a and 10 chips 52b can be disposed on one support 62. Therefore, in order to dispose 240 chips 52a, four supports 62 are required, and in order to dispose 40 chips 52b, four supports 62 are required. Therefore, in the pattern 2, a total of four supports 62 are required.

In the pattern 3 illustrated in Fig. 7(c), 40 chips 52a and 15 chips 52b can be disposed on one support 62. Therefore, six supports 62 are required to dispose 240 chips 52a, and three supports 62 are required to dispose 40 chips 52b. Therefore, in the pattern 3, a total of six supports 62 are required.

In the pattern 4 illustrated in Fig. 7(d), 20 chips 52a and 20 chips 52b can be disposed on one support 62. Therefore, in order to dispose 240 chips 52a, 12 supports 62 are required, and in order to dispose 40 chips 52b, two supports 62 are required. Therefore, in the pattern 4, a total of 12 supports 62 are required.

Next, determination section 24 selects a pattern which minimizes the number of supports 62 to be used based on the above calculation result. As described above, the pattern 1 requires eighth supports 62, the pattern 2 requires four supports 62, the pattern 3 requires six supports 62, and the pattern 4 requires 12 supports 62. Therefore, in the present Embodiment, determination section 24 selects the pattern 2 in which the number of required supports 62 is minimum. Then, determination section 24 sets chips 52a and 52b to be disposed in the selected the pattern 2. That is, determination section 24 sets region 70 in which chips 52a are disposed as a range in which chips 52a can be disposed in 6 rows × 10 columns, and sets region 72 in which chips 52b are disposed as a range in which chips 52b can be disposed in 2 rows × 5 columns. In this manner, determination section 24 sets the ranges of regions 70 and 72 on support 62.

Next, determination section 24 determines the disposing positions of chips 52a and 52b so as to dispose chips 52a and 52b in regions 70 and 72 set in Step S36, respectively (S38). Specifically, in the pattern 2 set in Step S36, chips 52a can be disposed in 6 rows × 10 columns in region 70 in which chips 52a are disposed, and chips 52b can be disposed in 2 rows × 5 columns in region 72 in which chips 52b are disposed. Therefore, determination section 24 determines that 60 chips 52a are disposed in region 70 and 10 chips 52b are disposed in region 72 in four supports 62.

Thereafter, computing device 20 transmits the information relating to the determined disposing positions of chips 52a and 52b to chip moving device 30 (S40), and chip moving device 30 respectively disposes chips 52a and 52b on support 62 according to the received information relating to the disposing positions of chips 52a and 52b (S42). In the present Embodiment, in multiple supports 62, region 70 in which chips 52a are disposed and region 72 in which chips 52b are disposed are the same as each other. Therefore, the same program can be used when chips 52a and 52b are moved by chip moving device 30.

In Embodiments 1 and 2 described above, the disposing positions of chips 52a and 52b are determined by computing device 20 included in chip mounting device 10 (more specifically, determination section 24 included in computing device 20), but a configuration is not limited to this. Chip mounting device 10 may dispose chips 52a and 52b on support 62 according to the information relating to the determined disposing position of chips 52a and 52b, and computing device 20 including chip information storage section 22 and determination section 24 need not be included in chip mounting device 10. For example, computing device 20 including chip information storage section 22 and determination section 24 may be included in a management device (not illustrated) which manages the manufacture of package 50, and the information relating to the determined disposing positions of chips 52a and 52b may be transmitted from the management device to chip mounting device 10.

Although one chip 52 is sealed in package 50 to be manufactured in Embodiments 1 and 2 described above, a configuration is not limited to this. For example, multiple chip 52 may be sealed in a package. Even in this case, it is possible to dispose chips 52 on support 62 as a unit of multiple chips 52 sealed in one package. For example, as illustrated in Fig. 8, even when chip unit 152 including two types of chips 52c and 52d as a unit is disposed on support 62, region 70 in which chips 52a are disposed and region 74 in which chip units 152 are disposed can be set on one support body 62.

In Embodiments 1 and 2 described above, determination section 24 determines the disposing positions of two types of chips 52a and 52b, but the type of chip 52 is not limited to two types, and disposing positions of three or more types of chips 52 may be determined.

Technical elements described in the present specification or the drawings exhibit technical usefulness alone or in various combinations, and are not limited to combinations described in claims at the time of filing. In addition, the technology exemplified in the present specification or the drawings simultaneously achieves multiple purposes, and achieving one of the purposes itself has technical usefulness.

## Claims

1. A determination device for determining a disposing position of a chip disposed on a support used to manufacture a Fan-Out Wafer Level Package or a Fan-Out Panel Level Package, the determination device comprising:
a first chip information acquisition section configured to acquire first chip information relating to a type of a first-type chip and the number of the first-type chips to be supplied;
a second chip information acquisition section configured to acquire second chip information relating to a type of a second-type chip and the number of the second-type chips to be supplied, the second-type chip being different from the first-type chip; and
a determination section configured to determine disposing positions of the first-type chip and the second-type chip based on the first chip information and the second chip information,
wherein when the first-type chip and the second-type chip are disposed on the same support, an area of a region in which the first-type chip is disposed and an area of a region in which the second-type chip is disposed are changeable.

2. The determination device according to claim 1,
wherein when the first-type chip and the second-type chip are disposed on N (N is a natural number of 2 or more) supports, the determination section determines the disposing positions of the first-type chip and the second-type chip such that the region in which the first-type chip is disposed and the region in which the second-type chip is disposed are at the same position on each of the N supports.

3. The determination device according to claim 1,
wherein when the first-type chip and the second-type chip are disposed on N (N is a natural number of 2 or more) supports, the determination section determines the disposing positions of the first-type chip and the second-type chip such that, in at least one support, only one of at least the first-type chip and the second-type chip is disposed on the support, and determines the disposing positions of the first-type chip and the second-type chip such that, in at least one other support, the first-type chip and the second-type chip are disposed on the support.

4. A chip mounting device for mounting a chip on a support, the chip mounting device comprising:
the determination device according to any one of claims 1 to 3; and
a moving device configured to move the chip onto the support according to a disposing position determined by the determination device.
